## Europäisches Patentamt

## European Patent Office

## Office européen des brevets

(19)

(11) Veröffentlichungsnummer: **0 021 269**
**A2**

(12) **EUROPÄISCHE PATENTANMELDUNG**

(21) Anmeldenummer: **80103289.7**

(22) Anmeldetag: **12.06.80**

(51) Int. Cl.³: **H 01 L 23/46**

(30) Priorität: **29.06.79 DE 2926342**

(43) Veröffentlichungstag der Anmeldung: **07.01.81**
**Patentblatt 81/1**

(84) Benannte Vertragsstaaten: **DE FR GB SE**

(71) Anmelder: **SIEMENS AKTIENGESELLSCHAFT Berlin und München, Postfach 22 02 61, D-8000 München 22 (DE)**

(72) Erfinder: **Block, Harry, Strümpellstrasse 20, D-8520 Erlangen (DE)**
Erfinder: **Wiesenbacher, Rudolf, Am Europakanal 4, D-8520 Erlangen (DE)**

(54) **Kühldose für scheibenförmige Halbleiterbauelemente.**

(57)    Die Erfindung betrifft eine Kühldose zur Flüssigkeitskühlung scheibenförmiger Halbleiterbauelemente, beispielsweise von Scheibenthyristoren oder Scheibendioden. Die Kühldose besteht aus zwei Abdeck- bzw. Halbschalen (1, 2), die flüssigkeitsdicht miteinander verbunden sind. Jede Halbschale besitzt eine Ausnehmung (1c, 2c). Beide Ausnehmungen (1c, 2c) bilden einen Hohlraum (5) in der Kühldose, in den Einlass- und Auslassöffnungen (3, 4) münden, die in der Seitenwand der Kühldose angeordnet sind. Durch einen plattenförmigen Kern (6) wird der Hohlraum (5) in zwei Strömungswege (5a, 5c) unterteilt. Vorzugsweise ist der Kern (6) linsenförmig mit zwei kugelkalottenförmigen Oberflächen (6a, 6c) ausgebildet und auch die beiden Ausnehmungen (1c und 2c) sind kugelkalottenförmig. Mit den beiden Strömungswegen (5a, 5b) erhält man einen grossflächigen Wärmeübergang bei guter Führung des Kühlmediums. Ausserdem wird das Kühlmedium praktisch kaum umgelenkt, so dass in der Kühldose nur ein geringer Druckverlust auftritt.

SIEMENS AKTIENGESELLSCHAFT        Unser Zeichen
Berlin und München               VPA **79 P 3 0 9 7** EUR

Kühldose für scheibenförmige Halbleiterbauelemente

Die Erfindung betrifft eine Kühldose für scheibenförmige Halbleiterbauelemente, mit zwei Abdeckschalen aus wärmeleitendem Material, deren Stirnflächen etwa plan und planparallel zueinander sind und die zur wärmeleitenden Verbindung mit einem Halbleiterbauelement bestimmt sind und mit einem Kern, der zwischen den Abdeckschalen befestigt ist, wobei jede Abdeckschale eine vom Kern begrenzte Ausnehmung für einen Störmungskanal für ein flüssiges Kühlmedium besitzt, der von einer Einlaß- zu einer Auslaßöffnung führt, die in der Seitenwand der Kühldose angeordnet sind.

Eine solche Kühldose ist aus der DE-PS 2 160 302 bekannt. Bei der bekannten Kühldose sind beide Abdeckschalen und der Kern zylinderförmig und besitzen den gleichen Durchmesser. Die Seitenwand der Kühldose wird durch die Seitenwand des Kerns gebildet und die Ein- und Auslaßöffnung mündet in je einer Bohrung im zylindrischen Kern, die von einer Stirnfläche des Kerns zur

Soe 2 Bim / 22.6.1979

anderen verlaufen. Jede Abdeckschale ist auf eine Stirnfläche des Kerns aufgesetzt und in jeder Abdeckschale
sind als Ausnehmungen ringförmige, konzentrische Nuten
angeordnet, die die beiden Bohrungen im Kern als Strömungswege miteinander verbinden. Der zylindrische Kern
und die mit den Strömungswegen versehenen Abdeckschalen
sind mit Ringnietverbindungen flüssigkeitsdicht zusammengehalten. Diese Kühldosen werden zur Kühlung einzelner Scheibenthyristoren oder Scheibendioden benutzt,
die zwischen zwei Kühldosen eingespannt sind oder sie
werden in sogenannten Thyristorsäulen zur Kühlung
mehrerer Scheibenthyristoren verwendet, wobei in einer
solchen Thyristorsäule Scheibenthyristoren nebeneinander gestapelt und eingespannt sind und an jeder Seite
eines Scheibenthyristors ein Kühlkörper eingefügt ist
und mit seiner Wärmeübergangsgläche am Scheibenthyristor
anliegt. Eine solche Thyristorsäule ist beispielsweise
aus der DE-PS 1 914 790 bekannt.

Der Wärmewiderstand und damit die Kühlleistung einer
Kühldose hängt im wesentlichen von der Größe der Metallfläche ab, an der das Kühlmedium vorbeiströmt. Bei der
bekannten Kühldose werden daher eine Vielzahl konzentrischer Nuten in die beiden Abdeckschalen als Strömungswege eingefräst. In diesen Strömungswegen wird das
Kühlmedium laufend umgelenkt, womit zwangsläufig ein
Druckverlust im Kühlmedium bewirkt wird, mit dem der
Querschnitt der Strömungswege und damit auch die Länge
des gesamten Strömungsweges begrenzt ist. Die Forderung,
einen möglichst großflächigen Wärmeübergang zwischen dem
Metall der Kühldose und dem Kühlmedium zu erhalten, ist
daher bei der bekannten Kühldose durch den baulich bedingten Druckverlust begrenzt.

Es besteht die Aufgabe, eine Kühldose der eingangs genannten Art so auszugestalten, daß bei einer großen Wärmeübergangsfläche Druckverluste praktisch vermieden werden.

Erfindungsgemäß wird diese Aufgabe dadurch gelöst, daß die Seitenwände beider Abdeckschalen flüssigkeitsdicht miteinander verbunden sind und die Seitenwand der Kühldose bilden, daß jede Abdeckschale nur eine Ausnehmung besitzt, daß durch die Ausnehmungen beider Abdeckschalen ein Hohlraum gebildet ist, dessen in der Verbindungslinie der Ein- und Auslaßöffnung liegende größte Querschnittsfläche etwa der größten Querschnittsfläche des Kerns entspricht und daß der Kern plattenförmig und in dem Hohlraum so angeordnet ist, daß er die Ein- und Auslaßöffnung zu je einer gesonderten Öffnung für jede Ausnehmung unterteilt.

Bei der erfindungsgemäßen Kühldose ist für jede Stirnfläche, die zur Kühlung eines Halbleiterbauelementes vorgesehen ist, ein einziger Strömungshohlraum vorhanden. Damit erhält man einerseits einen großflächigen Wärmeübergang über die gesamte Stirnfläche der Kühldose, andererseits wird das Kühlmedium nicht oder nur geringfügig abgelenkt, so daß Druckverluste nicht auftreten. In den durch die Unterteilung mit dem plattenförmigen Kern geschaffenen beiden Hohlräumen kann es allenfalls zu Wirbelbildungen kommen, die jedoch den Wärmeübergang zwischen Metalloberfläche und Kühlmedium sogar noch verbessern.

Vorzugsweise besitzt der Kern ein Profil, das sich in Richtung auf die Ein- bzw. Auslaßöffnung verjüngt. Mit einem so profilierten Kern wird das Kühlmedium zu dem Bereich geführt, in dem das Halbleiterbauelement am stärksten Wärme entwickelt, was zu einer Verbesserung der Kühlleistung der Kühldose führt.

Die Ausnehmungen der Abdeckschalen können an das Profil des Kerns angepaßt sein. Durch diese Anpassung der Ausnehmungen der Abdeck- bzw. Halbschalen wird die Führung des Kühlmittels verbessert. Die mit dieser Führung des Kühlmediums verbundene Umlenkung ist gering, so daß der hierdurch bewirkte Druckabfall praktisch vernachlässigbar ist.

Bei zylinderförmigen Abdeckschalen und zylinderförmigem Kern, ist es vorteilhaft, den Kern linsenförmig auszubilden und etwa zentrisch in dem von den Ausnehmungen gebildeten Hohlraum anzuordnen. Dieses Profil des Kerns, bei dem die beiden Oberflächen kugelkalottenförmig sein können, ist fertigungstechnisch mit einem Drehautomaten einfach zu realisieren, so daß diese Ausbildungsform auch für eine Serienfertigung geeignet ist. Vorteilhaft ist es, auch die Ausnehmungen jeder Abdeckplatte kugelkalottenförmig auszubilden. Auch diese kugelkalottenförmigen Einsenkungen sind als Drehteile rationell und damit serienmäßig zu fertigen. In Verbindung mit einem linsenförmigen Kern erhält man außerdem bei dieser Ausführungsform eine strömungstechnisch gute Führung des Kühlmediums bei vernachlässigbarem Druckabfall und eine großflächige und gleichmäßige Wärmeabfuhr und damit eine gute Kühlleistung der Kühldose.

Zwischen dem Kern und jeder Abdeckschale können im Bereich der Ausnehmungen Abstandshalter angeordnet sein. Mit diesen Abstandshaltern wird der Kern mittig zentriert. Außerdem stellen die Abstandshalter eine wärmeleitende Verbindung zwischen dem Kern und beiden Abdeckschalen her. Schließlich wird durch die Abstandshalter eine Verwirbelung der Kühlflüssigkeit herbeigeführt, was den Wärmeübergang verbessert. Diese Verwirbelung kann mit einer versetzten Anordnung der Abstandshalter noch verbessert werden.

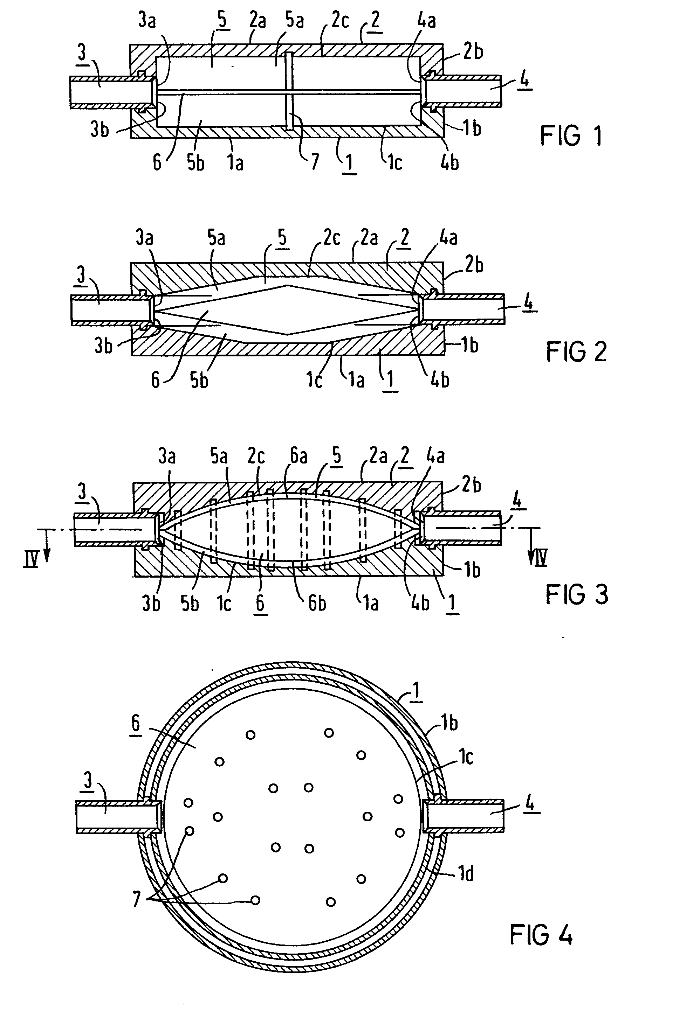

Im folgenden wird die erfindungsgemäße Kühldose beispielhaft anhand der Figuren 1 bis 4 näher erläutert. In den Figuren sind einige Ausführungsbeispiele der erfindungsgemäßen Kühldose dargestellt. Gleiche Bauteile sind mit gleichen Bezugszeichen versehen.

Figur 1 zeigt einen Teilschnitt durch die einfachste Ausführungsform der erfindungsgemäßen Kühldose. Die Kühldose besteht aus zwei Abdeck- bzw. Halbschalen 1 und 2, deren plane und zueinander planparallelen Stirnflächen 1a und 2a zur wärmeleitenden Verbindung mit scheibenförmigen Halbleiterbauelementen, beispielsweise mit Scheibenthyristoren, dienen. Die Abdeckschalen 1 und 2 sind aus gut wärmeleitendem Material, vorzugsweise einem Metall, gefertigt. An ihrer Seitenwand 1b und 2b sind beide Abdeckschalen 1 und 2 flüssigkeitsdicht miteinander verbunden. Die flüssigkeitsdichte Verbindung kann bei Abdeckschalen 1 und 2 aus Stahl bzw. Edelstahl durch Löten, bei Abdeckschalen aus Aluminium durch Verschweißen erfolgen. Als geeignet hat sich auch erwiesen, die Abdeckschalen 1 und 2 miteinander zu verkleben oder eine Ringniet- oder Bördelverbindung vorzusehen. In der Seitenwand der Kühldose, die von den Wandteilen 1b und 2b der Abdeckschalen 1 und 2 gebildet sind, sind als Ein- und Ausflußöffnungen 3 und 4 Schlauchtüllen angeordnet. Um einen möglichst langen Strömungsweg in der Kühldose zu erhalten, sind die Ein- und Ausflußöffnungen 3 und 4 an sich gegenüberliegenden Seitenwandbereichen der Kühldose anzuordnen. Jede Abdeckschale 1 und 2 besitzt eine Ausnehmung 1c bzw. 2c, die beim Ausführungsbeispiel rechteckförmigen Querschnitt besitzt. Durch die Ausnehmungen 1c und 2c wird im Inneren der Kühldose ein Hohlraum 5 geformt. Der Hohlraum 5 wird vom Kern 6 in zwei Hohlräume, die als Strömungswege 5a und 5b dienen, unterteilt, wobei im Ausführungsbeispiel der Kern 6 als Platte ausgeführt ist. Der Kern 6 kann ebenfalls aus einem Metall, gegebenenfalls aber auch aus einem schlechteren Wärmeleiter, beispielsweise einem Kunststoff hergestellt sein. Der plattenförmige Kern 6 ist dabei so mit Hilfe eines Abstandshalters 7 mittig im Hohlraum 5 angeordnet, daß er sowohl die Zuflußöffnung 3 als auch die Abflußöffnung 4 in jeweils eine gesonderte Zuflußöffnung 3a und 3b und eine gesonderte Abflußöffnung 4a und 4b für jeden Strömungsweg 5a und 5b unterteilt. Bei der in Figur 1 gezeigten Kühldose erhält man in der Sohle der Einsenkungen 2c und 3c einen großflächigen Wärmeübergang zwischen dem Kühlmedium und den Abdeckschalen 2 bzw. 3. Da außerdem die Wärmestromwege im Metall zwischen den Stirnflächen 2a und 3a der Abdeckschalen und den Sohlen der Ausnehmungen 2c und 3c sehr klein sind, besitzt die Kühldose einen geringen Wärmewiderstand und damit eine hohe Kühlleistung. Eine Ablenkung des strömenden Kühlmediums erfolgt praktisch nicht, weswegen in den Strömungswegen 5a und 5b kein Druckabfall im Kühlmedium vorhanden ist.

Eine zweite Ausführungsform zeigt der Teilschnitt nach Figur 2. Vom Ausführungsbeispiel nach Figur 1 unterscheidet sich diese Kühldose durch den mit einem Profil versehenen Kern 6. Dabei ist der Kern 6 so gestaltet, daß er sich sowohl in Richtung auf die Einflußöffnung 3 als auch auf die Abflußöffnung 4 verjüngt. Beim Ausführungsbeispiel erhält damit der Kern 6 den Querschnitt einer Raute. Mit diesem Profil des Kerns 6 wird das Kühlmedium in den Bereich, in dem die stärkste Wärmeentwicklung des Halbleiterbauelements auftritt, in die Nähe der Sohlen der Einsenkungen 1c und 2c geführt, was die Wärmeabfuhr verbessert. Außerdem sind beim Ausführungsbeispiel nach Figur 2 auch die Einsenkungen 2c und 3c an das Profil des Kerns 6 angepaßt. Die strömungstechnische Führung des Kühlmediums wird damit verbessert.

Durch das Profil des Kerns 6 und die Anpassung der Einsenkungen 1c und 2c an dieses Profil wird das strömende Kühlmedium geringfügig abgelenkt. Der dabei auftretende Druckverlust ist jedoch vernachlässigbar und wird durch die Verbesserung der Kühlleistung aufgrund der besseren Strömungsführung des Kühlmediums weit ausgeglichen.

Eine dritte Ausführungsform ist in Figur 3 dargestellt. Bei dieser Ausführungsform sind sowohl die beiden Abdeckschalen 1 und 2 als auch der Kern 6 zylinderförmig. Der Kern 6 besitzt einen linsenförmigen Querschnitt, wobei seine beiden Oberflächen 6a und 6b kugelkalottenförmig ausgebildet sind. Auch die Einsenkungen 1c und 2c sind kugelkalottenförmig und damit an das Profil des Kerns 6 angepaßt. Damit erhält man Strömungswege 5a und 5b mit einer guten Führung des Kühlmediums, wobei die Umlenkung - auch im Vergleich zur Ausführungsform nach Figur 2 - nur geringfügig ist und damit kein Druckverlust auftritt.

Figur 4 zeigt einen Schnitt längs der Linie IV-IV der Figur 3. Die Figur 4 verdeutlicht die Anordnung der Abstandshalter 7, mit denen der Kern 6 mittig und zentriert in dem Hohlraum 5 gehalten wird. Die Abstandshalter 7 sind versetzt in Bezug auf die Strömungsrichtung von der Einlaßöffnung 3 zur Auslaßöffnung 4 angeordnet. Damit erreicht man eine gute Verwirbelung des Kühlmediums und damit eine Verbesserung des Wärmeübergangs und der Kühlleistung der Kühldose. Bei einem Kern 6 aus Metall, beispielsweise Stahl, Kupfer oder Aluminium                sorgen die ebenfalls aus Metall gefertigten Abstandshalter 7 für eine gute Wärmeleitung zwischen den beiden Abdeckschalen 1 und 2 und dem Kern 6. In Figur 4 ist außerdem noch eine Nut 1d in der Abdeckschale 1 zu erkennen, die beispielsweise zum Verlöten der beiden Abdeckschalen mit einem Lot gefüllt werden kann.

Wegen ihrer zylindrischen Form ist die Ausführungsform der Kühldose nach Figur 3 und 4 fertigungstechnisch besonders günstig. Sowohl die Abdeckschalen 1 und 2 als auch der Kern 6 können mit Drehautomaten gefertigt werden. Lediglich die Öffnungen für die Anschlußnippel 3 und 4 lassen sich daher nicht in einem einzigen Fertigungsgang anbringen. Damit ist die Ausführungsform der Kühldose nach Figur 3 und 4 wegen ihrer rationellen Herstellung und Bearbeitung auch für die Serienfertigung besonders günstig.

Anzufügen ist noch, daß die Ausnehmungen 1c und 2c der beiden Abdeckschalen unterschiedlich tief sein können. Dies kann dazu führen, daß die flüssigkeitsdichte Verbindung beider Abdeckschalen 1 und 2 in der Nähe oder in der Stirnfläche einer der Abdeckschalen erfolgt.

4 Figuren
7 Patentansprüche

Patentansprüche

1. Kühldose für scheibenförmige Halbleiterbauelemente, mit zwei Abdeckschalen aus wärmeleitendem Material, deren Stirnflächen etwa plan oder planparallel zueinander sind und die zur wärmeleitenden Verbindung mit einem Halbleiterbauelement bestimmt sind und mit einem Kern, der zwischen den Abdeckschalen befestigt ist, wobei jede Abdeckschale eine vom Kern begrenzte Ausnehmung für einen Strömungskanal für ein flüssiges Kühlmedium besitzt, der von einer Einlaß- zu einer Auslaßöffnung führt, die in der Seitenwand der Kühldose angeordnet sind, d a d u r c h   g e k e n n -
z e i c h n e t ,   daß die Seitenwände (1b, 2b) beider Abdeckschalen (1, 2) flüssigkeitsdicht miteinander verbunden sind und die Seitenwand der Kühldose bilden, daß jede Abdeckschale (1, 2) nur eine Ausnehmung (1c, 2c) besitzt, daß durch die Ausnehmungen (1c, 2c) beider Abdeckschalen (1, 2) ein Hohlraum (5) gebildet ist, dessen in der Verbindungslinie der Ein- und Auslaßöffnung (3, 4) liegende größte Querschnittsfläche etwa der größten Querschnittsfläche des Kerns (6) entspricht und daß der Kern (6) plattenförmig und in dem Hohlraum (5) so angeordnet ist, daß er die Ein- und Auslaßöffnungen (3 bzw. 4) zu je einer gesonderten Öffnung (3a, 3b bzw. 4a, 4b) für jede Ausnehmung (1c, 2c) unterteilt.

2. Kühldose nach Anspruch 1, d a d u r c h   g e - k e n n z e i c h n e t ,   daß der Kern (6) ein Profil besitzt, das sich in Richtung auf die Ein- bzw. Auslaßöffnung (3 bzw. 4) verjüngt.

3. Kühldose nach Anspruch 2, d a d u r c h   g e - k e n n z e i c h n e t ,   daß die Ausnehmungen (1c,2c) der Abdeckschalen (1, 2) an das Profil des Kerns (6) angepaßt sind.

4. Kühldose nach einem der Ansprüche 1 und 2 mit zylinderförmigen Abdeckschalen und zylinderförmigem Kern, d a d u r c h   g e k e n n z e i c h n e t , daß der Kern (6) linsenförmig ausgebildet ist und etwa zentrisch in dem von den Ausnehmungen (1c, 2c) gebildeten Hohlraum (5) angeordnet ist.

5. Kühldose nach Anspruch 4, d a d u r c h   g e - k e n n z e i c h n e t ,   daß der Kern (6) zwei kugelkalottenförmige Oberflächen (6a, 6b) besitzt.

6. Kühldose nach Anspruch 5, d a d u r c h   g e - k e n n z e i c h n e t ,   daß die Ausnehmungen (1c, 2c) jeder Abdeckplatte (1, 2) kugelkalottenförmig ist.

7. Kühldose nach einem der Ansprüche 1 bis 6, d a - d u r c h   g e k e n n z e i c h n e t , daß zwischen Kern (6) und jeder Abdeckschale (1, 2) im Bereich der Ausnehmungen (1c, 2c) Abstandshalter (7) angeordnet sind.

FIG 1

FIG 2

FIG 3

FIG 4